# EUROPÄISCHE PATENTSCHRIFT

(11) **EP 2 139 109 B1**
(45) Veröffentlichungstag und Bekanntmachung des Hinweises auf die Patenterteilung: **12.01.2011**
(21) Anmeldenummer: 09009622.3
(22) Anmeldetag: 09.02.2007
(51) Int. Cl.: H03G 11/02, H04B 5/02, G06K 19/07, H03G 11/00

(54) **Verfahren zur Spannungsbegrenzung bei einem Transponder**
Method for voltage limitation for a transponder
Procédé destiné à limiter la tension dans un transpondeur

(30) Priorität: 15.02.2006 DE 102006006912
(43) Veröffentlichungstag der Anmeldung: 30.12.2009
(62) Teilanmeldung aus: 07002790.9
(73) Patentinhaber: Atmel Automotive GmbH, 74072 Heilbronn (DE)
(72) Erfinder: Berhorst, Martin, Dipl.-Ing., 69123 Heidelberg (DE); Schneider, Peter, Dipl.-Phys., 74855 Hassmersheim (DE); Kurz, Alexander, Dipl.-Ing. (FH), 74523 Schwabisch Hall (DE)
(74) Vertreter: Koch, Bertram

(56) Entgegenhaltungen:
- EP-A- 1 589 656
- US-A- 5 815 355
- US-A1- 2004 099 738
- US-A1- 2005 156 710
- RAO YU ET AL: "Circuitry for a wireless microsystem for neural recording microprobes" PROCEEDINGS OF THE 23RD. ANNUAL INTERNATIONAL CONFERENCE OF THE IEEE ENGINEERING IN MEDICINE AND BIOLOGY SOCIETY. 2001 CONFERENCE PROCEEDINGS. (EMBS). INSTANBUL, TURKEY, OCT. 25 - 28, 2001, ANNUAL INTERNATIONAL CONFERENCE OF THE IEEE ENGINEERING IN M, Bd. VOL. 1 OF 4. CONF. 23, 25. Oktober 2001 (2001-10-25), Seiten 761-764, XP010593486

## Beschreibung

Die Erfindung betrifft ein Verfahren zur Spannungsbegrenzung gemäß dem Oberbegriff des Patentanspruchs 1. Darüber hinaus betrifft die Erfindung eine Schaltung zur Spannungsbegrenzung bei einem Transponder gemäß dem Oberbegriff des Patentanspruchs 6.

Ein solches Verfahren und eine solche Schaltung sind per se insbesondere durch RFID-Anwendungen (RFID = Radio Frequency Identification) bekannt. Unter einer RFID-Anwendung wird hier jede Anwendung verstanden, bei der ein Sendeschwingkreis einen induktiv gekoppelten Empfangsschwingkreis mit Energie versorgt und über den Empfangsschwingkreis Daten ausliest. Solche Verbindungen werden zum Beispiel zur Objektidentifikation verwendet, wobei ein Sendeschwingkreis eines Lesegerätes (reader) über einen Empfangsschwingkreis ein mit einer Marke (tag) ausgezeichnetes Objekt anspricht und Informationen abruft.

Für die Kontaktaufnahme erzeugt der Sendeschwingkreis des Lesegeräts ein hochfrequentes Magnetfeld, das in einer Induktivität eines Empfangsschwingkreises, der sich in der Nähe des Lesegerätes befindet, eine Wechselspannung induziert. Die in dem Empfangsschwingkreis induzierte Wechselspannung wird gleichgerichtet und dient zum Beispiel zur Energieversorgung einer an den Empfangsschwingkreis angeschlossenen integrierten Schaltung. Darüber hinaus lässt sich auch aus der induzierten Wechselspannung eine Taktfrequenz ableiten, die der integrierten Schaltung, also zum Beispiel einem Mikroprozessor und/oder einem Speicherelement als Systemtakt zur Verfügung gestellt werde kann. Durch die Ergänzung der Induktivität des Sendeschwingkreises und/oder Empfangsschwingkreises mit Kapazitäten, insbesondere mit parallel liegenden Kapazitäten, zu Schwingkreisen werden Resonanzeffekte erzielt, die den Wirkungsgrad der Energieübertragung erheblich verbessern.

Eine Übertragung von Daten vom Lesegerät zum Empfangsschwingkreis (downlink) kann zum Beispiel durch Einschalten und Ausschalten des Magnetfeldes erfolgen. Für einen Datentransport in umgekehrte Richtung vom Empfangsschwingkreis zum Lesegerät wird die so genannte Lastmodulation verwendet, die eine hinreichende Nähe (Abstand kleiner 0,16 Wellenlänge) von Sende- und Empfangsschwingkreis erfordert. Bei hinreichender Nähe kommt es zur transformatorischen Kopplung, bei der sich die Energieaufnahme der Empfangsspule durch eine Rückwirkung auf den Sendeschwingkreis in Spannungsänderungen am Sendeschwingkreis abbildet. Gesteuerte Modulationen der Last, also der Impedanz des Empfangsschwingkreises, rufen daher Spannungsänderungen im Sendeschwingkreis hervor, die für eine Datenübertragung auswertbar sind.

Mit zunehmender Güte der im Empfangsschwingkreis verwendeten Induktivitäten, also mit zunehmendem Verhältnis von Blindwiderstand zu Wirkwiderstand verringern sich die Dämpfung des Schwingkreises und die Breite der Resonanzkurve. Die Verwendung von Spulen höhere Güte bewirkt also eine höhere Frequenzselektivität und, bei gleicher Spannung auf der reader-Seite, eine höhere Spannung auf der tag-Seite, was die Reichweite der Kommunikationsverbindung vergrößert. Bei kleinen Abständen zwischen Reader und Tag können je nach Sendeleistung im Tag derart große Spannungen induziert werden, dass eine im Tag vorhandene integrierte Schaltung zerstört werden kann.

Aus der DE 10 2004 020 816 A1 ist es bekannt, die Spannung am Empfangsschwingkreis auf bestimmte Werte zu reduzieren oder zu begrenzen, welche im Folgenden als erste Klemmspannung bezeichnet wird. Ferner wird im Rahmen der Lastmodulation zwischen einer ersten Spannung d.h. ersten Klemmspannung und einer zweiten niedrigeren Spannung umgeschaltet. Hierzu werden Sperrschichtbauelemente zwischen Schwingkreisanschlüssen und ein Bezugs- oder Massepotential geschaltet. Eine untere Klemmspannung wird zum Beispiel dadurch realisiert, dass über den Sperrschichtbauelementen deren Durchlassspannung abfällt, wobei der Spannungsabfall wegen der exponentiellen Abhängigkeit des Stroms von der Spannung in erster Näherung stromunabhängig ist.

Als Folge wirken die Sperrschichtbauelemente auch bei hohen Spulenströmen wie eine zuverlässige Begrenzung der Schwingkreisspannung auf einen zugehörigen Wert. Dies ist insbesondere bei Systemen mit Induktivitäten hoher Güte von Bedeutung, die bei räumlicher Nähe von Sendesehwingkreis und Empfangsschwingkreis sonst unerwünscht hohe Spannungen verursachen können.

Die obere Klemmspannung kann durch eine in Reihe mit umgekehrter Durchlassrichtung geschaltete Zenerdiode realisiert sein, die gesteuert oder geschaltet kurzzuschließen ist. Im kurzgeschlossenen Zustand erfolgt die beschriebene Begrenzung auf die untere Klemmspannung, während im nicht kurzgeschlossenen Zustand die Durchbruchspannung der Zenerdiode für eine additiven Spannungsversatz sorgt, der in der Summe mit den genannten Durchlassspannungen eine obere Klemmspannung definiert. Im Zustand mit kurzgeschlossener Zenerdiode fließt ein vergleichsweise großer Strom aus dem Empfangsschwingkreis heraus, was dem belasteten Zustand des Schwingkreises entspricht. Entsprechend wird die Stromentnahme aus dem Schwingkreis sowie die Belastung des Schwingkreises durch Öffnen des Kurzschlusses über der Zenerdiode verringert.

Bei der Lastmodulation aus der DE 10 2004 020 816 A1 ist das folgende Problem beobachtet worden: Wenn beim Einschalten der Modulation, also beim Begrenzen der Schwingkreisspannung auf die untere Klemmspannung, gerade ein hoher Spulenstrom induziert wird, so fließt dieser unter Umständen über die Überbrückung der Zenerdiode und die in Durchlassrichtung geschalteten übrigen Sperrschichtbauteile ab, wobei die Schwingkreisspannung unter die untere Klemmspannung und auch unter einen Schwellenwert fallen kann, der zur Detektion von Schwingungen (Pulsen) der Schwingkreisspannung dient. Es kann also bei ungünstigen Phasenbedingungen beim Einschalten der Last vorkommen, dass die Spannung am Sendeschwingkreis aufgrund der Rückwirkung für eine oder mehrere Perioden unter eine Detektionsschwelle sinkt, was die Informationsübertragung verfälscht. Dadurch kann es zu einem Datenverlust bei der Informationsübertragung zum Lesegerät kommen.

Wird nämlich bei einem hohen induzierten Spulensrom die Modulation eingeschaltet, so sorgen die Sperrschichtbauteile für eine Begrenzung der Schwingkreisspannung auf einen durch die Sperrschichtbauteile vorbestimmten Wert. Die Dioden wirken in dieser Phase wie eine Gleichspannungsquelle und setzen somit dem Spulenstrom keine ausreichende Dämpfung entgegen, so dass die induzierte Schwingung verändert wird. Die Folge ist eine Verbreiterung der gerade anliegenden Taktphase (Pulsverbreiterung), die zumindest zur teilweisen Auslöschung der Folgeschwingung führt. Sie tritt dadurch in Erscheinung, dass mindestens eine Schwingung in der Amplitude zu klein für eine vorgegebene Detektionsschwelle ist.

Aus der Druckschrift US 5 815 355 ist eine Schaltung und ein Verfahren zur Spannungsbegrenzung für einen Transponder bekannt. Hierbei wird die Spannung an den Schwingkreisspulen durch die Ansteuerung eines parallel geschalteten Transistors begrenzt.

In dem Konferenzbericht "Circuitry for a wireless micorsystem for neural re-cording microprobes" veröffentllicht in Annual International Conference of The IEEE Engineering in M, Bd. Vol. 1 of 4. Conf. 23, 25. Oktober 2001 Seiten 761- 764 XP010593486, ist eine Spannungsbegrenzerschaltung für ein induktiv gekoppeltes System offenbart, die bei hohen induzierten Spannungen die angeschlossenen Schaltung vor Zerstörung schützt. Nachteilig ist, dass die Schaltung erst für ein gleichgerichtetes Signal einsetzbar ist.

Vor diesem Hintergrund besteht die Aufgabe der Erfindung in der Angabe eines Verfahrens und einer Schaltungsanordnung zur Spannungsbegrenzung in einem Transponder, das die Nachteile des Standes der Technik verringert, sowie in der Ansprüchen beschrieben.

Weitere Vorteile ergeben sich aus der Beschreibung und den beigefügten Figuren. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in den Zeichnungen dargestellt und werden in der nachfolgenden Beschreibung näher erläutert. Es zeigen, jeweils in schematischer Form:
- Fig. 1: einen Sende- und Empfangsschwingkreis mit Elementen zur Lastmo- dulation für eine erste Spannungshalbwelle
- Fig. 2: den Sende- und Empfangsschwingkreis aus Fig.1 mit Elementen zur Lastmodulation für eine zweite Spannungshalbwelle
- Fig. 3: einen weiteren Sende- und Empfangsschwingkreis mit Elementen zur Lastmodulation für eine erste Spannungshalbwelle
- Fig. 4: den Sende- und Empfangsschwingkreis aus Fig.3 mit Elementen zur Lastmodulation für eine zweite Spannungshalbwelle
- Fig. 5: den Verlauf der Schwingkreisspannungen U_{L}, U_{C1}: U_{C2}
- Fig. 6: ein gewünschtes Modulationsverhalten

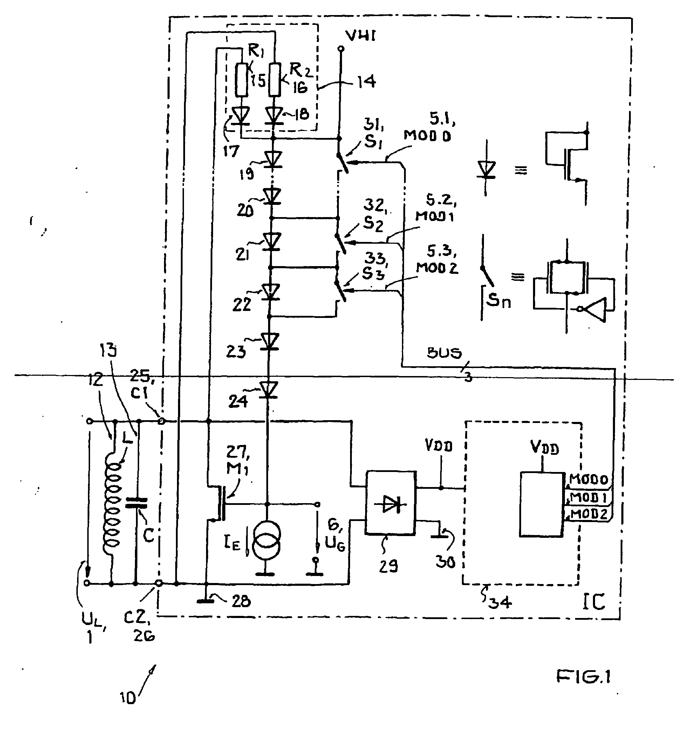

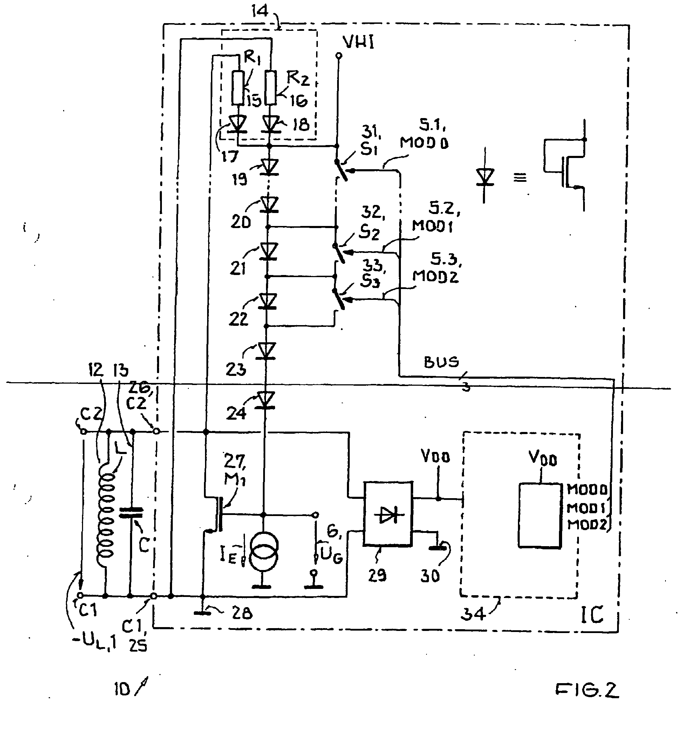

Bei den Ausführungsbeispielen gemäß der Figur 1 und der Figur 2 handelt es sich nicht um einen Teil der Erfindung, der Gegenstand des vorliegenden Anspruchsbegehrens ist. Die Fig. 1 und Fig. 2 zeigen einen Sende- und Empfangsschwingkreis 10 eines Empfangsteils oder tags. Parallel zum Schwingkreis 10, der eine Induktivität L 12 und eine Kapazität C 13 umfasst, liegt zwischen einem ersten Schwingkreisanschluss C₁ 25 und einem zweiten Schwingkreisanschluss C₂ 26 ein Sperrschichtbauteil 27, vorzugsweise ein NMOS-Transistor. Am Ausgang des Sperrschichtbauteils 27 liegt ein Bezugspotentialanschluss 28, der ein Massepotential für die Schaltung dar stellt. Da das Sperrschichtbauteil 27 zwischen Source (Quelle) und Drain (Senke) umschalten kann, kann die Schaltung in der vorliegenden Form sowohl für eine erste als auch für eine zweite Spannungshalbwelle verwendet werden.

Ebenfalls parallel zum Schwingkreis 10 und zwischen dem ersten C₁ 25 und zweiten Schwingkreisanschluss C₂ 26, liegt eine Reihenschaltung aus Polaritätswechselschaltung 14 und Dioden 19, 20, 21, 22, 23, 24, die zur Ansteuerung des Sperrschichtbauteils 27 dienen. Hierbei können die Dioden als NMOS-Transistoren realisiert werden, die als Diode geschaltet sind. Parallel zum Sperrschichtbauteil 27 liegt weiterhin eine Gleichrichterschaltung 29 mit einem weiteren Bezugspotentialanschluss 30.

Die Polaritätswechselschaltung 14 besteht aus zwei parallelen Reihenschaltungen, die jeweils einem ohmschen Widerstand R₁ 15 bzw. R₂ 16 und eine Diode 17 bzw. 18 umfassen, wobei die Durchflussrichtung der Dioden 17, 18 unterschiedlich ist.

Die Dioden 19 bis 24 können durch Schalter S₁ 31, S₂ 32, S₃ 33 überbrückt werden, die von der Steuerschaltung 34 über kaskadierenden MOD-Signale MOD₀, MOD₁ und MOD₂ betätigt werden. Die Schalter 31, 32, 33 werden bevorzugt als Transistoren, insbesondere als MOS-Transistoren realisiert.

Das Sperrschichtbauteil 27 dient zunächst zur Begrenzung der Schwingkreisspannung U_{L} 1 zwischen den Anschlüssen 25 und 26 des Sende- und Empfangsschwingkreises 10 bei offenen Schaltern 31, 32 und 33. In diesem Zustand begrenzt das Sperrschichtbauteil 27 jeweils dann, wenn der Potentialunterschied zwischen dem Bezugspotentialanschluss 28, 30 und einem der Anschlüsse 25 oder 26 die Durchlassspannung des Sperrschichtbauteils 27 überschreitet. Dieser Wert definiert die obere Begrenzungsspannung oder erste Klemmspannung U_{KL} 2.2.

Beim Überbrücken der Dioden 19 bis 24 durch die Schalter 31, 32 und 33, wobei diese zur stufenförmigen Modulation der Spannung nacheinander und nicht zeitgleich geschlossen werden, klemmt das Sperrschichtbauteil 27 die Schwingkreisspannung U_{L} 1 auf einen niedrigeren Wert UL_{MOD}2.1.

Durch Öffnen und Schließen der Schalter 31, 32, 33 moduliert die Steuerschaltung 34 den Wert der Schwingkreisspannung U_{L} 1 entsprechend der zu übertragenden Datenfolge. Wie beschrieben bildet sich diese Modulation des Sende- und Empfangsschwingkreises 10 des tags als Modulation der Last des Sende- und Empfangsschwingkreises des Lesegeräts unter der Voraussetzung einer transformatorischen Kopplung.

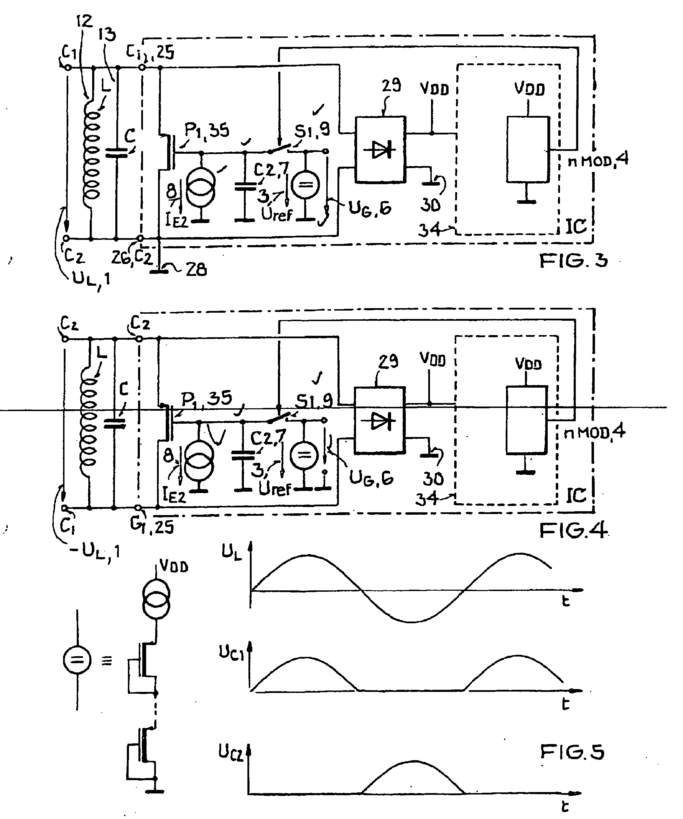

Fig. 3 und Fig. 4 zeigen einen weiteren Sende- und Empfangsschwingkreis 10 eines Empfangsteils oder tags. Hierbei zeigt Fig. 3 eine Schaltung für eine erste Spannungshalbwelle und Fig. 4 die Schaltung aus Fig. 3 für eine zweite Spannungshalbwelle. Parallel zum Schwingkreis 10, der eine induktivität L 12 und eine Kapazität C 13 umfasst, liegt zwischen einem ersten Schwingkreisanschluss C₁ 25 und einem zweiten Schwingkreisanschluss C₂ 26 ein Sperrschichlbauteil 35, vorzugsweise ein PMOS-Transistor. Am Ausgang des Sperrschtchtbauteits 35 liegt ein Bezugspotentiatanschtuss 28, der ein Massepotential für die Schaltung darstellt. Zur Ansteuerung des Sperrschichtbauteils 35 dienen eine Stromquelle I_{E}. die wiederum einen Entladestrom zum Entladen einer parallel geschalteten Kapazität 7 zur Verfügung stellt, sowie eine Spannungsquelle U_{ref} 3. Dabei ist zwischen der Kapazität 7 und der Spannungsquelle U_{ref} 3 ein Schalter S₁ 9 angeordnet, der mittels eines inversen Signals nMOD 4 betätigt wird.

Das Sperrschichtbauteil 35 dient zur Begrenzung der Schwingkreisspannung U_{L} 1 auf den Wert der oberen Klemmspannung U_{KL} 2.2 zwischen den Anschlüssen 25 und 26 des Sende- und Empfangsschwingkreises 10. Wenn der Schalter S₁ 9 geschlossen ist, liegt am Sperrschichtbauteil 35 die Spannung U_{ref} 3 an, die durch die vorgegebene Spannung U_{G} 6 am Gate begrenzt wird und somit nicht über die Schweilspannung des PMOS-Transistors hinausgehen kann. Sobald der Schalter S₁ 9 mittels des nMOD 4 Signals der Steuerschaltung 34 geschlossen wird, wird der Kondensator 7 auf den Wert U_{ref} 3aufgeladen und anschließend mittels des Entladestroms der Stromquelle I_{E2} 8 entladen. Die Folge davon ist, dass die Spannung U_{G} 6 am Gate linear auf null absinkt. Dadurch wird die Schwingkreisspannung U_{L} 1 auf eine zweite, kleinere Klemmspannung U_{LMOD} 2.1 begrenzt, die der Schwellspannung des PMOS-Translstors entspricht.

Fig. 5 zeigt den Verlauf der Schwingkreisspannung U_{L} 1 sowie den Verlauf der jeweiligen Spannungshalbwellen U_{C1} und U_{C2} an den beiden Schwingkreisanschlüssen C, 25 und C₂ 26 Die Schwingkreisspannung U_{L} 1 ergibt sich als Differenz aus den Spannungswerten an den Anschlüssen. U_{L} = U_{C1}-U_{C2}.

Wenn UL 1 positiv ist, werden bei der Schaltung gemäß Fig.1 und Fig. 3 der Schwingkreisanschluss C₂ über den Gleichrichter 29 mit einer internen Masse 30 verbunden. Im gegenteiligen Fall, wenn U_{L} 1 negativ ist, wird entsprechend der Darstellung in den Fig. 2 und Fig. 4 der Schwingkreisanschluss C₁ 26 mit der internen Masse 30 verbunden.

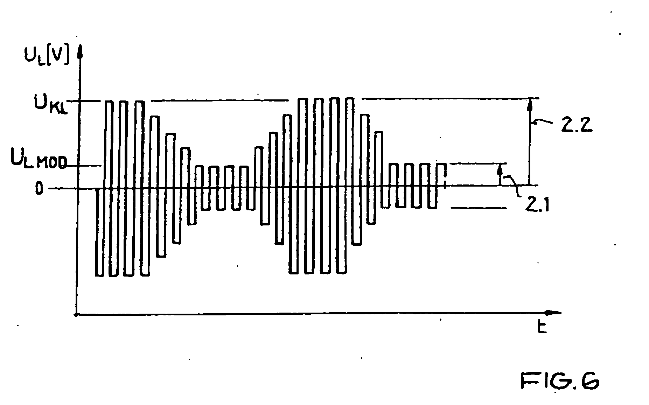

Fig. 6 zeigt einen erwünschten Verlauf der resultierenden Schwingkreisspannung UL im Empfangsschwingkreis unter dem Einfluss einer gesteuerten Lastmodulation gemäß der vorliegenden Erfindung über der Zeit t. Die großen Amplituden 2.2 stellen sich bei offenen Schaltern 31, 32, 33 gemäß Fig. 1 und Fig.2 ein und die kleinen Amplituden 2.1 stellen sich bei geschlossenen Schaltern 31, 32, 33 ein, mit denen die Dioden 19, 20, 21, 22 überbrückt werden ein.

### Bezugszeichenliste

- 1: U_{L} Schwingkreisspannung
- 2.1: UL_{MOD} untere Klemmspannung (modulierte Spannung)
- 2.2: U_{KL} obere Klemmspannung
- 3: U_{ref} Spannungsreferenz
- 4: n_{MOD} inverses Signal
- 5.1: Modulationssignal MOD₀
- 5.2: Modulationssignal MOD₁
- 5.3: Modulationssignal MOD₂
- 6: U_{G} Gatespannung
- 7: C₂ Kondensator
- 8: IE₂ Stromquelle Entladestrom
- 9: Schalter S₁
- 10: Sende - und Empfangsschwingkreis
- 11: Tag
- 12: Induktivität L
- 13: Kapazität C
- 14: Polaritätswechselschaltung
- 15: Ohmscher Widerstand R1
- 16: Ohmscher Widerstand R2
- 17: Diode bei R1
- 18: Diode bei R2
- 19: Diode
- 20: Diode
- 21: Diode
- 22: Diode
- 23: Diode
- 24: Diode
- 25: Erster Schwingkreisanschluss C₁
- 26: Zweiter Schwingkreisanschluss C₂
- 27: Sperrschichtbauteil M1
- 28: Bezugspotentialanschluss
- 29: Gleichrichterschaltung
- 30: Bezugspotentialanschluss
- 31: Schalter S₁
- 32: Schalter S₂
- 33: Schalter S₃
- 34: Steuerschaltung (Digital-Analog-Konverter)
- 35: Sperrschichtbauteil P₁

## Patentansprüche

1. Verfahren zur Spannungsbegrenzung bei einem Transponder mit einem ersten Sende- und Empfangsschwingkreis (10), der einen ersten Schwingkreisanschluss (25) und einen zweiten Schwingkreisanschluss (26) aufweist , wobei
• ein steuerbares Sperrschichtbauelement (P1), mit einem Eingang, einen Ausgang und einem Steuereingang (27) vorgesehen ist, und
• der Eingang mit dem ersten Schwingkreisanschluss (25) verschaltet ist,
• der Ausgang mit dem zweiten Schwingkreisanschluss (26) verschaltet ist, und wobei von der Basisstation im Sende- und Empfangschwingkreis (10) zwischen dem ersten und zweiten Schwingkreisanschluss (25, 26) eine Wechselspannung induziert wird,
die im Sende- und Empfangsschwingkreis (10) induzierte Wechselspannung auf einen ersten Spannungswert (2.1) begrenzt wird, indem der Steuereingang (27) des Sperrschichtbauelementes (P1) mittels eines Schalters (S1) mit einer Spannungsquelle (Uref3) verbunden wird,
**dadurch gekennzeichnet, dass**
durch Öffnen des Schalters (S1) der Steuereingang (27) von der Spannungsquelle (Uref3) getrennt wird und mittels Entladung einen Kapasität (C2) die induzierte Wechselspannung auf einen zweiten Spannungswert (2.2) begrenzt wird.

2. Verfahren nach Anspruch 1,
**dadurch gekennzeichnet, dass**
durch Öffnen des Schalters (S1) der Steuereingang (27) von der Spannungsquelle (Uref3) getrennt wird, sodass die induzierte Wechselspannung auf einen zweiten Spannungswert (2.2), der kleiner als der erste Spannungswert ist, begrenzt wird.

3. Verfahren nach Anspruch 2,
**dadurch gekennzeichnet, dass**
zur Lastmodulation die Spannung abwechselnd zwischen dem zweiten Spannungswert (2.2) und dem ersten Spannungswert (2.1) begrenzt wird.

4. Verfahren nach Anspruch 2 oder Anspruch 3,
**dadurch gekennzeichnet, dass**
die Änderung von dem zweiten Spannungswert (2.2) auf dem ersten Spannungswert (2.1) kontinuierlich erfolgt, indem nach dem Trennen von der Spannungsquelle (Uref3) die mit dem Steuereingang (27) verbundene Kapasität (C2) entladen wird.

5. Verfahren nach einem der Anspruch 4,
**dadurch gekennzeichnet, dass**
eine stufenlose Modulation durchgeführt wird, indem die Kapasität (C2) von einer Steuerschaltung (34) mittels des Schalters (S1) mit der Spannungsquelle (Uref3) verbunden und getrennt wird.

6. Schaltung zur Spannungsbegrenzung bei einem Transponder aufweisend, einem ersten Sende- und Empfangsschwingkreis (10), der einen ersten Schwingkreisanschluss (25) und einen zweiten Schwingkreisanschluss (26) aufweist , wobei
• ein steuerbares Sperrschichtbauelement (P1), mit einem Eingang, einen Ausgang und einem Steuereingang (27) vorgesehen ist, und
• der Eingang mit dem ersten Schwingkreisanschluss (25) verschaltet ist,
• der Ausgang mit dem zweiten Schwingkreisanschluss (26) verschaltet ist,
• und wobei von der Basisstation im Sende- und Empfangschwingkreis (10) zwischen dem ersten und zweiten Schwingkreisanschluss (25, 26) eine Wechselspannung induziert wird zur Begrenzung der induzierten Wechselspannung auf einen ersten Spannungswert (2.1) der Steuereingang (27) mittels eines Schalters (S1) mit einer Spannungsquelle (Uref3) verschaltet ist,
**dadurch gekennzeichnet, dass**
zwischen dem Steuereingang (27) und dem Schalter (S1) eine Kapasität (C2) in Parallelschaltung vorgesehen ist.

7. Schaltung nach Anspruch 6 ,
**dadurch gekennzeichnet, dass**
der Schalter (S1) mit einem Steuereingang vorgesehen ist und an dem Steuereingang des Schalters (S1) eine Spannung (nMOD) einer Steuerschaltung (34) anliegt, und wobei der Schalter (S1) mittels der Spannung (nMOD) die Spannungsquelle (Uref3) mit dem Steuereingang (27) des Sperrschichtbauelementes (P1) verbindet oder trennt.

8. Schaltung nach Anspruch 6 oder Anspruch 7,
**dadurch gekennzeichnet, dass**
zum Entladen die Kapasität (C2) zwischen dem Steuereingang (27) und die Kapasität (C2) eine Stromquelle (8) vorgesehen ist.

## Claims

1. Method for voltage limitation in a transponder with a first transmitting and receiving oscillator circuit (10) comprising a first oscillator circuit connection (25) and a second oscillator circuit connection (26), wherein
- a controllable insulating layer component (P1) with an input, an output and a control input (27) is provided and
- the input is connected with the first oscillator circuit connection (25),
- the output is connected with the second oscillator circuit connection (26), and wherein an alternating voltage is induced by the base station in the transmitting and receiving oscillator circuit (10) between the first and second oscillator circuit connections (25, 26), the alternating voltage induced in the transmitting and receiving circuit (10) is limited to a first voltage value (2.1) in that the control input (27) of the insulating layer component (P1) is connected by means of a switch (S1) with a voltage source (Uref3),
**characterised in that** by opening the switch (S1) the control input (27) is separated from the voltage source (Uref3) and the induced alternating voltage is limited to a second voltage value (2.2) by means of discharging a capacitance (C2).

2. Method according to claim 1, **characterised in that** by opening the switch (S1) the control input (27) is separated from the voltage source (Uref3) so that the induced alternating voltage is limited to a second voltage value (2.2) smaller than the first voltage value.

3. Method according to claim 2, **characterised in that** for load modulation the voltage is limited in alternation between the second voltage value (2.2) and the first voltage value (2.1).

4. Method according to claim 2 to claim 3, **characterised in that** the change from the second voltage value (2.2) to the first voltage value (2.1) takes place continuously **in that** after the separation from the voltage source (Uref3) the capacitance (C2) connected with the control input (27) is discharged.

5. Method according to claim 4, **characterised in that** a stepless modulation is carried in that the capacitance (C2) is connected with and separated from the voltage source (Uref3) by a control circuit (34) by means of the switch (S1).

6. Circuit for voltage limitation in a transponder comprising a first transmitting and receiving oscillator circuit (10) having a first oscillator circuit connection (27) and a second oscillator circuit connection (26), wherein
- a controllable insulating layer component (P1) with an input, an output and a control input (27) is provided and
- the input is connected with the first oscillator circuit connection (25),
- the output is connected with the second oscillator circuit connection (26),
- and wherein an alternating voltage is induced by the base station in the transmitting and receiving oscillator circuit (10) between the first and second oscillator circuit connections (25, 26), and for limitation of the induced alternating voltage to a first voltage value (2.1) the control input (27) is connected by means of a switch (S1) with a voltage source (Uref3),
**characterised in that** a capacitance (C2) is provided in parallel connection between the control input (27) and the switch (S1).

7. Circuit according to claim 6, **characterised in that** the switch (S1) is provided with a control input and a voltage (nMOD) of a control circuit (34) is applied to the control input of the switch (S1), and wherein the switch (S1) by means of the voltage (nMOD) connects the voltage source (Uref3) with or separates it from the control input (27) of the insulating layer component (P1).

8. Circuit according to claim 6 or claim 7, **characterised in that** for discharging the capacitance (C2) a current source (8) is provided between the control input (27) and the capacitance (C2).

## Revendications

1. Procédé pour la limitation de tension dans un transpondeur présentant un premier oscillateur d'émission/réception (10) qui comporte une première connexion d'oscillateur (25) et une deuxième connexion d'oscillateur (26) dans lequel :
. un composant semi-conducteur commandable (P1) présentant une entrée, une sortie et une entrée de commande (27) est prévu,
. l'entrée est reliée à une première connexion d'oscillateur (25),
. la sortie est reliée à une deuxième connexion d'oscillateur (26) dans lequel on induit par la station de base un changement de tension dans le circuit oscillant (10) d'émission/réception entre la première et la deuxième connexion d'oscillateur (25, 26),
on limite ce changement de tension induite dans le circuit oscillant d'émission/réception (10) à une première valeur de tension (2.1) dans lequel, l'entrée de commande (27) du composant semi-conducteur (P1) est reliée par un interrupteur (S1) à une source de tension (Uref3),
**caractérisé en ce que** :
on sépare l'entrée de commande (27) de la source de tension (Uref3) par l'ouverture de l'interrupteur (S1) et par la décharge d'une capacité (C2) on limite le changement de tension induite à une deuxième valeur de tension (2.2).

2. Procédé selon la revendication 1 **caractérisé en ce que** par l'ouverture de l'interrupteur (S1) on sépare l'entrée de commande (27) de la source de tension (Uref3) de façon à limiter le changement de la tension induite à une deuxième valeur (2.2) qui est inférieure à la première valeur de tension.

3. Procédé selon la revendication 2 **caractérisé en ce que** pour la modulation en charge, la tension est limitée alternativement entre la deuxième valeur de tension (2.2) et la première valeur de tension.

4. Procédé selon la revendication 2 ou la revendication 3 **caractérisé en ce que** la modification faisant passer de la deuxième valeur de tension (2.2) à la première valeur de tension (2.1) s'effectue de façon continue, procédé dans lequel on décharge la capacité reliée à l'entrée de commande après la séparation de la source de tension (Uref3).

5. Procédé selon la revendication 4 **caractérisé en ce que** l'on effectue une modulation continue selon laquelle la capacité (C2) est reliée à, ou séparée de la source de tension (Uref3) au moyen d'un circuit de commande (34) par un interrupteur (S1).

6. Circuit pour la limitation de tension dans un transpondeur comportant un premier circuit émetteur/récepteur (10) présentant une première connexion d'oscillateur (25) et une deuxième connexion d'oscillateur (26) dans lequel :
. un composant semi-conducteur commandable (P1) présentant une entrée, une sortie et une entrée de commande (27) est prévu,
. l'entrée est reliée à la première connexion d'oscillateur (25),
. la sortie est reliée à la deuxième connexion d'oscillateur (26)
. et dans lequel on induit par la station de base un changement de tension dans le circuit oscillant d'émission/réception (10) entre la première et deuxième connexion d'oscillateur (25, 26) pour la limitation du changement de tension induite à une première valeur de tension (2.1), l'entrée de commande (27) est reliée par un interrupteur (S1) à la source de tension (Uref3),
**caractérisé en ce qu'**une capacité (C2) est montée en parallèle entre l'entrée de commande (27) et l'interrupteur (S1)

7. Circuit selon la revendication 6, **caractérisé en ce que** l'interrupteur (S1) comporte une entrée de commande et **en ce qu'**est appliquée une tension (nMOD) d'un circuit de commande (34) sur l'entrée de commande de l'interrupteur et **en ce que** l'interrupteur (S1) relie ou sépare la source de tension (Uref3) de l'entrée de commande du composant semi-conducteur (P1) au moyen de la tension (nMOD).

8. Circuit selon la revendication 6 ou 7 **caractérisé en ce qu'**une source de tension (8) est prévue entre l'entrée de commande (27) et la capacité (C2) pour décharger la capacité (C2).
